# EUROPÄISCHE PATENTSCHRIFT

(11) **EP 0 626 720 B1**
(45) Veröffentlichungstag und Bekanntmachung des Hinweises auf die Patenterteilung: **08.03.2000**
(21) Anmeldenummer: 93108665.6
(22) Anmeldetag: 28.05.1993
(51) Int. Cl.: H01L 21/18, H01L 21/20, H01L 21/76, G01R 1/073

(54) **Verfahren zur Herstellung eines Plattenstapels aus direkt miteinander verbundenen Siliziumplatten**
Process for manufacturing a stack of directly bonded silicon wafers
Procédé de fabrication d'un empilement de substrats de silicium directement soudés

(43) Veröffentlichungstag der Anmeldung: 30.11.1994
(73) Patentinhaber: International Business Machines Corporation, Armonk, N.Y. 10504 (US)
(72) Erfinder: Bayer, Thomas, W-7032 Sindelfingen (DE); Greschner, Johann, Dr. Dipl.-Phys., W-7041 Pliezhausen 1 (DE); Meissner,Klaus,Dipl.-Phys., D-71083 Herrenberg(Kayh) (DE); Stoehr, Roland, W-7045 Nufringen (DE)
(74) Vertreter: Rach, Werner, Dr.

(56) Entgegenhaltungen:
- EP-A- 0 078 339
- EP-A- 0 367 536
- EP-A- 0 475 653
- US-A- 4 883 215
- US-A- 4 939 101
- JAPANESE JOURNAL OF APPLIED PHYSICS. Bd. PART 1, Nr. 5A , Mai 1992 , TOKYO JP Seiten 1535 - 1540 C.F. YEH ET AL. 'THE NOVEL PREPARATION OF P-N JUNCTION MESA DIODES BY SILICON-WAFER DIRECT BONDING (SDB.'
- JOURNAL OF APPLIED PHYSICS. Bd. 66, Nr. 3 , 1. August 1989 , NEW YORK US Seiten 1231 - 1239 S. BENGSTON ET AL. 'INTERFACE CHARGE CONTROL OF DIECTLY BONDED SILICON STRUCTURES'
- JOURNAL OF THE ELECTROCHEMICAL SOCIETY Bd. 139, Nr. 8 , August 1992 , MANCHESTER, NEW HAMPSHIRE US Seiten 2326 - 2330 S. J. YUN ET AL. 'STUDIES ON MICROVOIDS AT THE INTERFACE OF DIRECT BONDED SILICON WAFERS.'

## Beschreibung

Die vorliegende Erfindung betrifft ein Verfahren zur Herstellung Plattenstapel, die aus direkt miteinander verbundenen Siliziumplatten bestehen.

Klebstoff- bzw. verbindungsmittelfreie Verbindungstechniken erlauben höchste Präzision beim Zusammenfügen von Bauteilen. In der Mikromechanik kommen diese Techniken in zunehmendem Maße zum Einsatz. So ist es beispielsweise aus der Herstellung von Halbleiterbauteilen bekannt, Siliziumscheiben direkt miteinander zu verbinden, um damit Wafer herzustellen, die geeignet sind, solche zu ersetzen, die durch Aufwachsen einer oder mehrerer epitaxialer Schichten auf ein Siliziumsubstrat erhalten wurden. Dieses direkte Verfahren zur Verbindung von Siliziumwafern bietet die Möglichkeit, entweder sogenannte SOI-Strukturen (Silicon on Insulator) oder sogenannte SOS-Strukturen (Silicon on Silicon) herzustellen. Solche Verfahren sind beispielsweise in folgenden Druckschriften beschrieben: H. Ohashi et al., "Study of Si-Wafer directly bonded interface effect on Power Device Characteristics", S. 678, IEDM 1987; J.B. Lasky, "Wafer Bonding for silicon-on-insulator technologies", Appl. Phys. Lett. 48(1), 6. Januar 1986; H. Ohashi et al., "Improved dielectrically isolated device integration by SDB technique", S. 210, IEDM 1986; L. Ling et al., "Relationship between interfacial native oxide thickness and bonding temperature in directly bonded silicon wafer pairs", J. Appl. Phys, 71(3), 1. Februar 1992.

In IEEE Transactions on Electron Devices 25 (1978), S. 1241 beschreibt K. Petersen das sogenannte "Anodic Bonding" oder auch "Mallory Bonding", das meist verwendet wird, um durch hohe elektrische Felder und hohe Temperaturen Silizium und Glas zu verbinden. Das "Anodic Bonding" kann auch auf zwei Siliziumscheiben angewendet werden, wenn eine Scheibe vor dem Zusammenfügen mit Pyrex ^{R} (oder dotiertem Quarz) beschichtet wird (vgl. productronic, Die Fachzeitschrift für Elektronik-Fertigung und Test, Nr. 5 (1991), S. 439). Wegen der erforderlichen elektrischen Kontaktierung (es sind Spannungen von ca. 1000 V erforderlich) ist diese Methode jedoch nur vorteilhaft beim Zusammenfügen von zwei Teilen, nicht aber für das Verbinden eines ganzen Stapels von Silizium-Platten.

Mit Hilfe des "Fusion-Bonding" lassen sich zwei Siliziumflächen direkt miteinander verbinden (vgl. Ling et al., aaO). Nachteilig beim "Fusion-Bonding" sind die extremen Anforderungen an die zu verbindenden Oberflächen in Bezug auf Glattheit und Sauberkeit. Die Mikrorauhigkeit muß dabei im atomaren Bereich liegen. Für bestimmte mikromechanische Aufgabenstellungen benötigt man jedoch beidseitig polierte Wafer mit höchster Planparallelität. Nach bisherigen Erfahrungen sind aber gute Planparallelität und geringe Mikrorauhigkeit mit Hilfe der heutigen Läpp- und Polierprozesse nicht gleichzeitig zu erreichen. Wie bereits erwähnt, ist neben der geringen Mikrorauhigkeit für das "Silizium-Fusion-Bonding" auch größte Sauberkeit hinsichtlich kontaminierender Partikel notwendig, so daß große Anforderungen bezüglich Reinraumtechnik zu stellen sind.

Aus US-A-4 883 215 und EP-A-0 367 536 sind verschiedene Verfahren bekannt, um Siliziumwafern oder Halbleiten Stäbe durch eine SiO₂ Schicht zu verbinden.

Aufgabe der vorliegenden Erfindung ist es daher, ein kostengünstiges und zuverlässiges Verfahren zur direkten Verbindung von Siliziumplatten zur Verfügung zu stellen, das auch bei deutlich schlechterer Oberflächenrauhigkeit der Platten sowie bei erhöhter Anzahl kontaminierender Partikel ein zufriedenstellendes Verbinden der Platten erlaubt und somit keinen extrem hohen Reinraumanforderungen genügen muß.

Diese Aufgabe wird durch ein Verfahren gemäß Patentanspruch 1 gelöst.

In den Unteransprüchen sind weitere vorteilhafte Ausgestaltungen des erfindungsgemäßen Verfahrens dargestellt.

Das erfindungsgemäße Verfahren ermöglicht es, auf besonders einfache Art und Weise Siliziumplatten miteinander zu verbinden, ohne daß dabei extrem hohe Reinraumanforderungen erforderlich sind. Es zeigt weiterhin eine nur geringe Anfälligkeit gegenüber kontaminierenden Partikeln und gegenüber der Oberflächenqualität der Silizium-Wafer. Der vorgeschlagene Prozeß erlaubt einen Durchmessser der kontaminierenden Partikel bis zur doppelten Oxiddicke. Besonders vorteilhaft ist diese Verbindungstechnik bei bereits perforierten Siliziumplatten, da diese eine große "Randfläche" aufweisen, was zu einer besonders guten Verbindung führt. Durch diese Verbindungstechnik lassen sich bspw. Durchgangslöcher in Siliziumscheiben von nahezu beliebigen Aspektverhältnissen herstellen.

Ein weiterer Vorteil ist dabei, daß die lateralen Dimensionen einer Bohrung auch nach dem Verbinden durch einen weiteren Oxidationsprozeß oder durch Entfernen des Oxids und erneute Oxidation noch verändert werden können.

Ein zusätzlicher Vorteil des erfindungsgemäßen Verfahrens ist die Toleranz gegenüber einem nicht perfekten Zusammenfügen der Siliziumplatten.

Im folgenden wird das erfindungsgemäße Verfahren anhand der Zeichnungen näher erläutert.

Es zeigt
- Fig. 1: eine schematische Querschnittsdarstellung eines erfindungsgemäßen Plattenstapels mit einem Durchgangsloch,
- Fig. 2: einen nach dem erfindungsgemäßen Verfahren hergestellten Plattenstapel ohne die Durchführung des Press-Schritts,
- Fig. 3: einen nach dem erfindungsgemäßen Verfahren hergestellten Plattenstapel mit Durchführung des Press-Schritts,
- Fig. 4: einen Ausschnitt einer lichtoptischen Aufnahme eines Querschliffs durch einen erfindungsgemäßen Plattenstapel mit 30 Platten,
- Fig. 5: eine Vergrößerung der Aufnahme von Fig. 4,
- Fig. 6: einen erfindungsgemäßen Plattenstapel auf Alignment-Stiften,
- Fig. 7: einen erfindungsgemäßen Stapel mit Führungslöchern für Alignment-Stifte,
- Fig. 8: einen mit Oxid gefüllten Randspalt in einem erfindungsgemäßen Plattenstapel, und
- Fig. 9: einen durch KOH-Ätzen aufgeweiteten inneren Spalt zwischen zwei Siliziumplatten.

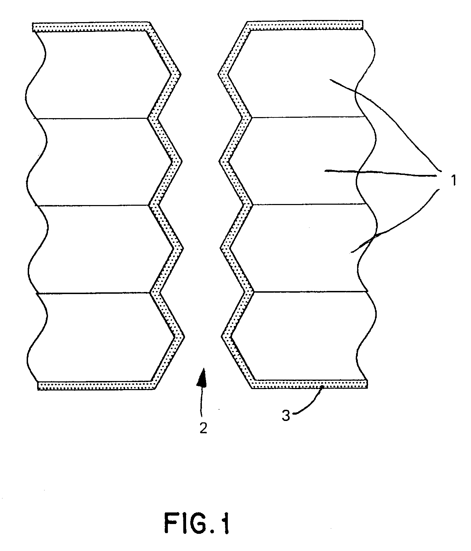

Die Oberflächen der in Fig. 1 im Schnitt gezeigten, zu verbindenden Siliziumplatten (1), deren Größe und Dicke vom erfindungsgemäßen Verfahren unabhängig sind und höchstens von der jeweiligen Anwendung abhängen, werden zunächst aktiviert. Dies geschieht durch eine Hydrophilierungsbehandlung, die bevorzugt darin besteht, daß die zu verbindenden Platten mit einer Schicht thermischen Oxids ≥ 0.5 µm, bevorzugt 1-3 µm, versehen werden, das anschließend durch gepufferte Flußsäure (BHF (5:1)) oder entsprechende Mittel wieder entfernt wird. Bei dieser Hydrophilierungsbehandlung werden an der Oberfläche der Platten OH-Gruppen angelagert, die dann Wasserstoffbrücken mit den OH-Gruppen einer zweiten, ebenfalls aktivierten Platte bilden. Die Platten können dabei bereits beliebig vorstrukturiert sein, insbesondere können sie bereits Bohrungen (Durchgangslöcher (2), etc.) aufweisen. Die Dicke des aufgebrachten Oxids ist hierbei unkritisch. Durch diese Behandlung werden evtl. bereits vordem Verbinden vorhandene organische Kontaminationen wie auch natives Oxid entfernt.

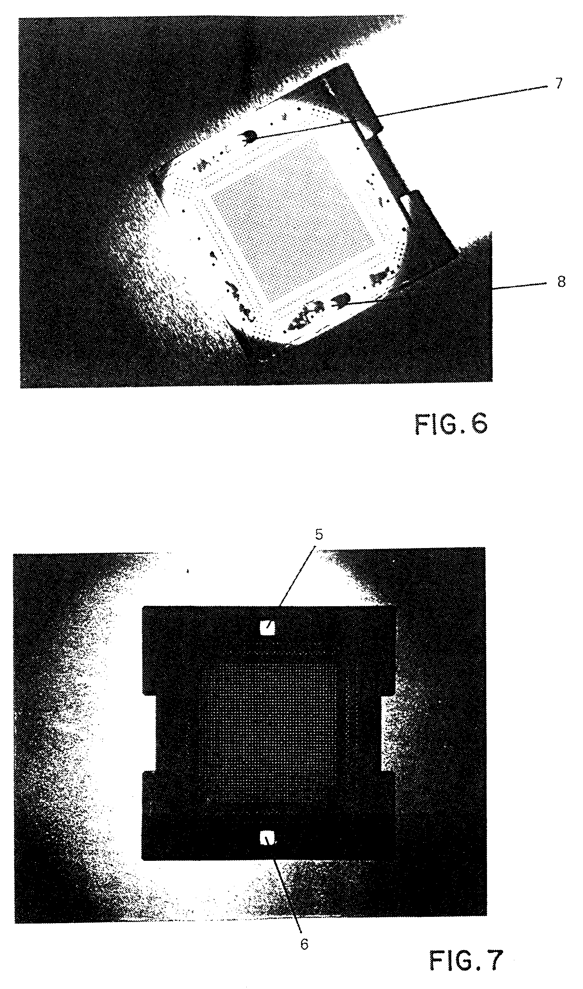

Nach einer gründlichen, mehrfachen Reinigung der aktivierten Platten durch Spülen mit einer Spülflüssigkeit, bspw. deionisiertem Wasser, werden die Platten in noch nassem Zustand in einer Stapelvorrichtung gestapelt, da im nassen Medium eine größere Reinheit der Platten als in der umgebenden Atmosphäre gewährleistet ist. Außerdem führt die Kapillarwirkung zu einer Annäherung der Oberflächen, so daß keine Verunreinigungen mehr zwischen die einzelnen Platten gelangen können. Dieses Stapeln kann z.B. in einfacher Weise mit Hilfe von zwei auf den Platten vorhandenen Innenlöchern (5,6) und einer Vorrichtung mit zwei Alignmentstiften (7,8), wie es in den Fig. 6 und 7 gezeigt ist, realisiert werden.

Anschließend wird der Stapel in einer vorgeheizten Preßform zusammengepreßt. Der Preßdruck liegt dabei im Bereich von 1,96 x 10⁵ N/m² (2 kp/cm²) bis 9,8 x 10⁵ N/m² (10 kp/cm²), und beträgt bevorzugt 4,9 x 10⁵ N/m² (5 kp/cm²). Die Temperatur der Preßform liegt im Bereich von etwa 110 bis etwa 300°C und beträgt bevorzugt etwa 130°C.

Die Preßform kann beispielsweise so ausgestaltet sein, daß der Siliziumplattenstapel zwischen zwei Metallplatten eingespannt ist, wobei die Kraft mittels eines Konus und einer Feder zentral auf die eine Metallplatte ausgeübt wird.

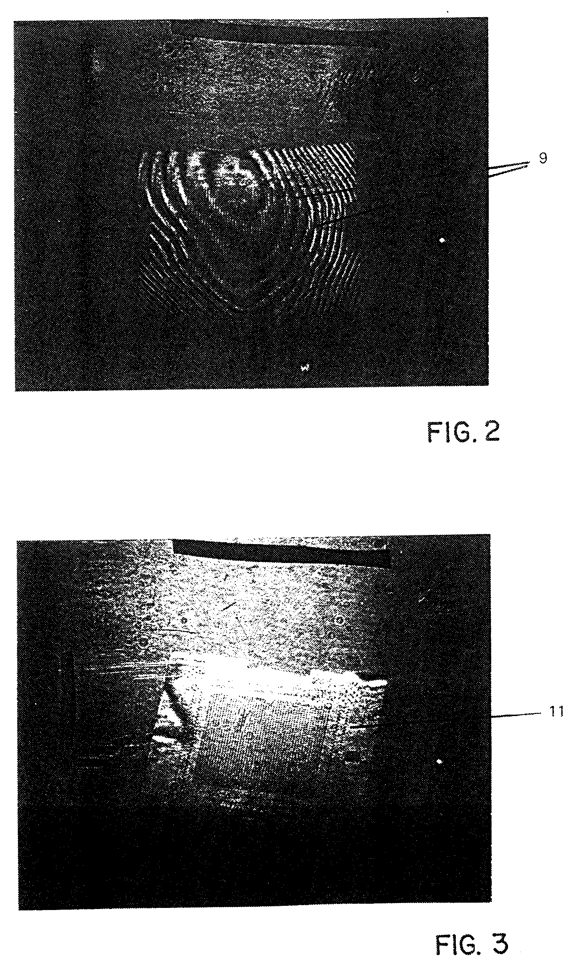

Es hat sich gezeigt, daß dieser Preßschritt während des Trocknens sehr wichtig für die spätere Planarität des verschweißten Stapels ist. Die Auswirkungen des Pressens wird durch die Fig. 2 und 3 veranschaulicht. Dargestellt sind Oberflächen in einem Contour Mapper ohne Pressen (Fig. 2) und mit Pressen (Fig. 3). In Fig. 2 kann anhand der Anzahl von Interferenzringen (9) eine Verbiegung des Stapels von mehreren Mikrometern festgestellt werden, während die Ebenheit des gepreßten Stapels (11) besser als 1 µm ist.

Nach dem Pressen wird die gesamte Preßform incl. des gepreßten Plattenstapels unverzüglich in eine Heizvorrichtung, bspw. einen Ofen, überführt. Hier erfolgt im Bereich von 110 bis 300°C, vorzugsweise bei 130°C, ein sogenanntes "Pre-Bonding", wobei eine zunächst weniger feste Verbindung zwischen den Platten entsteht. Dabei werden die Oberflächen durch Entfernen von überschüssigem Wasser und durch Druck einander angenähert, wobei sich Wasserstoffbrücken-Bindungen zwischen den Platten ausbilden können. Das "Pre-Bonding", das unter Schutzgasatmosphäre (bspw. N₂ oder Argon) stattfindet, erlaubt es, den Siliziumplattenstapel anschließend ohne die Stapelvorrichtung in die Oxidationsvorrichtung einzubringen. Der Prozeß des "Pre-Bonding" gestattet es also, das darauffolgende Hochtemperaturverbinden der Siliziumplatten bei entfernter Stapelvorrichtung durchführen zu können, ohne daß dabei das Substrat oder die Oxidationsvorrichtung kontaminiert werden.

Im letzten Schritt (vgl. Fig. 1) wird nun der Stapel in einer H₂O-Atmosphäre bei erhöhter Temperatur im Bereich von 950 bis 1200°C, bevorzugt bei etwa 1000°C, mit einem thermischen Oxid (3) überzogen und damit über die Umfangsflächen, d.h., die Außenkanten der Platten zusammengeschweißt. Die Dicke des thermischen Oxids ist abhängig von der Oxidationszeit. Sie liegt i.a. zwischen 1 und 5 µm, bevorzugt bei 2 µm. Das Aufwachsen einer Oxidschicht von 2 µm erfordert ca. 15 h Oxidationszeit.

Mit Hilfe dieser Verbindungstechnik lassen sich bei Platten, die bereits Bohrungen aufweisen, z.B. Durchgangslöcher von nahezu beliebigen Aspektverhältnissen, d.h., Verhältnissen von Bohrungstiefe zu Bohrungsdurchmesser, herstellen. Die lateralen Dimensionen bspw. eines Durchgangslochs (2), wie in Fig. 1 dargestellt, können auch nach dem Verbinden noch verändert werden. Durch einen weiteren Oxidationsprozeß läßt sich die Oxiddicke erhöhen, um die Bohrungen zu verkleinern. Auf der anderen Seite kann durch Entfernen des Oxids, bspw. mittels gepufferter Flußsäure, und erneuter Oxidation die Dimension der Bohrungen durch Verbrauch von Silizium vergrößert werden. Es hat sich gezeigt, daß das Vergrößern der Dimensionen beliebig oft wiederholt werden kann. Es wird bevorzugt das gesamte periphere Oxid entfernt, um eine gleichmäßige Schichtdicke nach dem erneuten Oxidieren zu gewährleisten. Dabei bleibt jedoch die Verbindung zwischen den einzelnen Siliziumplatten (1) erhalten. Die erneute Oxidation stellt dann die hohe Festigkeit der Verbindung immer wieder neu her.

Es läßt sich durch Zersägen mit anschließendem Polieren und naßchemischem Andekorieren der Cross-Section zeigen, daß sich zwischen den Siliziumplatten kein Oxid befindet, während die Umfangsflächen mit der durch den Prozeß erzielten Oxidschicht bedeckt sind.

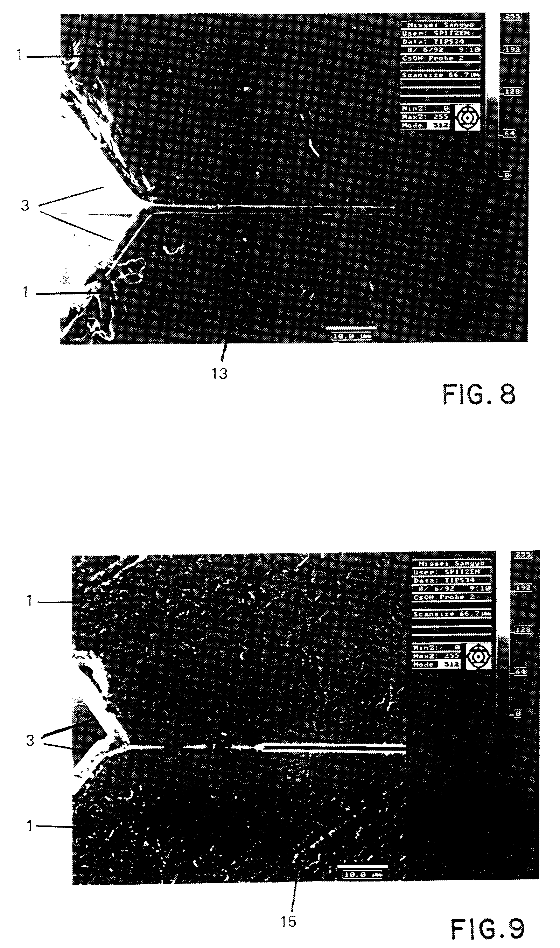

Bei Anwendung des erfindungsgemäßen Verfahrens ergibt sich eine große Toleranz gegenüber einem nicht perfekten Zusammenfügen der Siliziumplatten. Fig. 8 zeigt einen Randspalt (13), der sich beim Verschweißen der Platten mit Oxid gefüllt hat. Die Fig. 9 zeigt einen durch KOH-Ätzen aufgeweiteten inneren Spalt (15) zwischen zwei Siliziumplatten (1). Aus beiden Figuren ist zu erkennen, daß im Randbereich des Stapels dennoch eine dichte Verbindung durch thermisches Oxid (3) vorhanden ist.

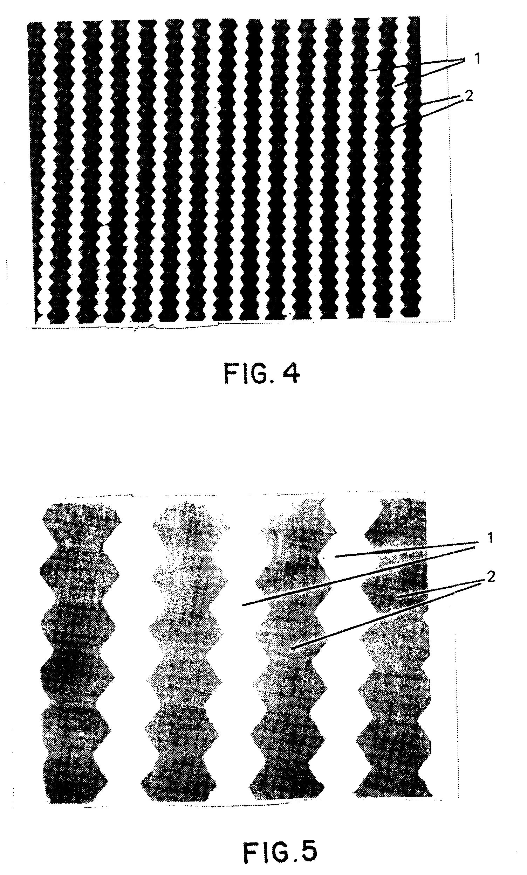

Mit Hilfe des erfindungsgemäßen Verfahrens lassen sich also Plattenstapel aus direkt miteinander verbundenen Siliziumplatten (1) herstellen, bei denen eine Vielzahl von Platten mit einer Präzision im Bereich von wenigen Mikrometern zueinander ausgerichtet sind. Fig. 4 zeigt einen Ausschnitt eines Querschliffs durch einen solchen Stapel aus 30 Siliziumscheiben (1). Die Innendurchmesser der Bohrungen (2) betragen an der engsten Stelle ca. 75 µm. In Fig. 5 ist eine Vergrößerung der Fig. 4 dargestellt, die zeigt, mit welcher Präzision die einzelnen Platten zueinander ausgerichtet sind.

Es zeigt sich, daß es mit Hilfe des erfindungsgemäßen Verfahrens gelingt, eine zuverlässige direkte Verbindung von Siliziumplatten zu erhalten, auch wenn keine erhöhten Reinraumanforderungen gestellt werden. So wurde beispielsweise eine zuverlässige Verbindung bei Bedingungen erhalten, die der Reinraumklasse 100000 und schlechter entspricht.

Die durch diese Technik hergestellten Plattenstapel können bspw. als Führungsplatten für Testköpfe, bei der Herstellung von Halbleiter-Chips für elektrische Tests und Burn-In. Auch ein Einsatz im optoelektronischen Packaging (Justage und Führung von Glasfasern) ist möglich.

## Patentansprüche

1. Verfahren zur Herstellung eines Plattenstapels, mit den Schritten:
a) Aktivieren durch Hydrophilierung der zu verbindenden Siliziumplatten (1),
b) Reinigen der aktivierten Platten (1) durch Spülen mit einer Spülflüssigkeit,
c) Einbringen der noch nassen Platten (1) in eine geeignete Stapelvorrichtung,
d) Pressen des Stapels,
e) Einbringen des Stapels in eine Heizvorrichtung und Heizen des Stapels unter Inertgasatmosphäre bei einer Temperatur von 110 bis 300°C,
f) Aufwachsen einer thermischen Oxidschicht in einer Oxidationsvorrichtung an den Außenkanten der Platten (1) in einer H2O-Atmosphäre bei erhöhter Temperatur, wobei die Siliziumplatten an den Umfangsflächen direkt miteinander fest verbunden werden,
dadurch gekennzeichnet, dass
das Pressen im Schritt d) in einer vorgeheizten Preßform mit einer Vorheiztemperatur zwischen 110 und 300°C durchgeführt wird,
im Schritt e) der Stapel mit der Preßform in die Heizvorrichtung eingebracht sind, und
vor dem Einbringen des Stapels in die Oxidationsvorrichtung der Plattenstapel aus der Stapelvorrichtung gelöst wird.

2. Verfahren nach Anspruch 1, dadurch gekennzeichnet, daß im Aktivierungsschritt a) die zu verbindenden Siliziumplatten mit einem thermischen Oxid versehen werden, das anschließend wieder entfernt wird.

3. Verfahren nach Anspruch 1 oder 2, dadurch gekennzeichnet, daß das Pressen in Schritt c) bei 1,96 x 10⁵ bis 9,8 x 10⁵ N/m² (2-10 kp/cm²), vorzugsweise bei 4,9 x 10⁵ N/m² (5 kp/cm²) durchgeführt wird, und daß die Vorheiztemperatur zwischen 110 und 300°C, bevorzugt 130°C beträgt.

4. Verfahren nach einem der Ansprüche 2 bis 3, dadurch gekennzeichnet, daß das Inertgas im Schritt e) Stickstoff oder Argon ist, und die Temperatur der Heizvorrichtung 110 bis 300°C, bevorzugt 130°C beträgt.

5. Verfahren nach einem der Ansprüche 1 bis 4, dadurch gekennzeichnet, daß das Aufwachsen der thermischen Oxidschicht in Schritt g) bei einer Temperatur von 950 bis 1200°C, bevorzugt 1000°C stattfindet.

6. Verfahren nach einem der Ansprüche 1 bis 5, dadurch gekennzeichnet, daß, falls die zu verbindenden Siliziumplatten Bohrungen aufweisen, die Dimensionen dieser Bohrungen nach dem Verbinden der Platten durch einen weiteren Oxidationsprozeß oder durch Entfernen des Oxids und erneute Oxidation verändert werden können.

7. Verwendung von nach einem der vorhergehenden Ansprüche hergestellten Plattenstapeln als Führungsplatten bei Testköpfen.

## Claims

1. Process for manufacturing a stack, comprising the steps of
a) activating by hydrophilation the surfaces of the silicon wafers (1) to be bonded,
b) cleaning the activated wafers (1) by rinsing with a rinsing fluid,
c) inserting the still-wet wafers (1) into a suitable stacking apparatus,
d) pressing the stack,
e) inserting the stack into a heating apparatus and heating the stack in an inert gas atmosphere at a temperature of 110 to 300°C,
f) growing a thermic oxide layer on the edges of the wafers (1) in an oxidation apparatus in an H₂O atmosphere at an elevated temperature, whereby the silicon wafers are rigidly directly bonded together on the peripheral surfaces,
characterized in that
the pressing in step d) is performed in an preheated press form at an preheating temperature between 110 and 300°C,
in step e) the stack together with the press form is inserted into the heating apparatus and the stack is freed from the stacking apparatus before inserting the stack into the oxidizing apparatus.

2. Process in accordance with Claim 1, characterized in that in the activating step a) the silicon wafers to be bonded are provided with a thermic oxide layer that is subsequently removed.

3. Process in accordance with Claim 1 or 2, characterized in that the pressing in step c) is carried out in the range of 1.96 x 10⁵ to 9.8 x 10⁵ N/m² (2-10 kp/cm²), preferably at 4.9 x 10⁵ N/m² (5 kp/cm²), and that the preheating temperature lies between 110 and 300°C, preferably is 130°C.

4. Process in accordance with any one of the Claims 2 to 3, characterized in that the inert gas in step e) is nitrogen or argon, and the temperature of the heating apparatus is 110 to 300°C, preferably 130°C.

5. Process in accordance with any one of the Claims 1 to 4, characterized in that the growing of the thermic oxide layer in step f) occurs at a temperature between 950 and 1200°C, preferably 1000°C.

6. Process in accordance with any one of the Claims 1 to 5, characterized in that, if the silicon wafers to be bonded contain bores, the dimensions of these bores can be altered after bonding of the wafers by a further oxidation process or by removal of the oxide and renewed oxidation.

7. Use of wafer stacks in accordance with any preceeding Claim as guiding plates for probes.

## Revendications

1. Procédé de fabrication d'un empilement de plaques, présentant les étapes consistant à:
a) activer par hydrophilation les plaques en silicium (1) à relier,
b) nettoyer les plaques activées (1) par rinçage avec un liquide de rinçage,
c) introduire les plaques (1) encore humides dans un dispositif d'empilement appropriées,
d) presser l'empilement,
e) introduire l'empilement dans un dispositif de chauffage et chauffer l'empilement sous une atmosphère de gaz inerte, à une température de 110 à 300°C,
f) mise en croissance d'une couche d'oxyde thermique dans un dispositif d'oxydation, sur les arêtes extérieures des plaques (1) dans une atmosphère de H2O, à une température augmentée, les plaques en silicium étant reliées rigidement entre elles directement aux surfaces périphériques,
caractérisé en ce que
le pressage effectué à l'étape d) est conduit dans une forme de pressage préchauffée ayant une température de préchauffage comprise entre 110 et 300°C,
à l'étape c) l'empilement avec le moule de pressage est introduit sur le dispositif de chauffage, et
avant introduction de l'empilement dans le dispositif d'oxydation, l'empilement de plaques est détaché du dispositif d'empilement.

2. Procédé selon la revendication 1, caractérisé en ce qu'à l'étape d'activation a), les plaques de silicium à relier sont dotées d'un oxyde thermique, qui est ensuite de nouveau enlevé.

3. Procédé selon la revendication 1 ou 2, caractérisé en ce que le pressage est effectué à l'étape c) à une pression de 1,96 x 105 jusqu'à 9,8 x 105N/m2 (2-10kp/cm2), de préférence à 4,9 x105 N/m2 (5kp/cm2), et la température de préchauffage est comprise entre 110 et 300°C, de préférence est de 130°C.

4. Procédé selon l'une des revendications2 à 3, caractérisé en ce que le gaz inerte utilisé à l'étape e) est de l'azote ou de l'argon et la température du dispositif de chauffage est de 110 à 300°C, de préférence de 130°C.

5. Procédé selon l'une des revendications1 à 4, caractérisé en ce que la mise en croissance de la couche d'oxyde thermique à l'étape g) s'effectue à une température de 950 à 1200°C, de préférence de 1000°C.

6. Procédé selon l'une des revendications 1 à 5, caractérisé en ce que, dans le cas où les plaques en silicium à relier présentent des perçages, les dimensions de ces perçages peuvent être modifiées après la liaison des plaques, par un procédé d'oxydation supplémentaire, ou bien par enlèvement de l'oxyde et une nouvelle oxydation.

7. Utilisation d'empilement de plaques fabriquées selon l'une des revendications précédentes, à titre de plaques de guidage pour des têtes de test.
